Europäisches Patentamt

(19) European Patent Office

Office européen des brevets

(11) Veröffentlichungsnummer: **0 093 996**
**B1**

(12) **EUROPÄISCHE PATENTSCHRIFT**

(45) Veröffentlichungstag der Patentschrift:
**27.11.85**

(51) Int. Cl.⁴: **H 03 K 19/092**

(21) Anmeldenummer: **83104319.5**

(22) Anmeldetag: **02.05.83**

(54) Schaltungsanordnung zur Pegelumsetzung.

(30) Priorität: **07.05.82 DE 3217237**

(43) Veröffentlichungstag der Anmeldung:
**16.11.83 Patentblatt 83/46**

(45) Bekanntmachung des Hinweises auf die Patenterteilung:
**27.11.85 Patentblatt 85/48**

(84) Benannte Vertragsstaaten:
**AT DE FR GB IT**

(56) Entgegenhaltungen:
**US - A - 3 755 693**
**US - A - 3 959 666**

**ELECTRONICS, November 1978 D. MRAZEK "Bit-slice
parts approach ECL speeds with TTL power levels",
Seiten 107-112
ELECTRONIC ENGINEERING, Oktober 1980 "ECL for
the TTL designer", Seiten 41, 44, 46, 50, 52**

(73) Patentinhaber: **Siemens Aktiengesellschaft, Berlin und
München Wittelsbacherplatz 2, D-8000 München 2 (DE)**

(72) Erfinder: **Lechner, Alexander, Dr., Dipl.-Ing.,
Dietrichsteinerstrasse 27, A-9583 Faak (AT)**

ACTORUM AG

## Beschreibung

Die Erfindung betrifft eine Schaltungsanordnung zur Pegelumsetzung von TTL-Logik-Pegeln zur ECL-Logik-Pegeln mit mindestens einem eingangsseitig von TTL-Logik-Pegeln beaufschlagten emittergekoppelten Stromschalter, an dessen Ausgang ECL-Logik-Pegel entnehmbar sind.

Pegelumsetzer (Converter) dienen zum Umsetzen der Logikpegel einer Schaltgliederfamilie auf die Logikpegel einer anderen Familie. Unter TTL-Pegeln werden dabei die Pegel der TTL (Transistor-Transistor-Logik)-Technik, aber im allgemeinen auch andere Standard-Logikpegel, wie z.B. die Pegel der RTL (Widerstands-Transistor-Logik), DTL (Dioden-Transistor-Logik)-Technik oder HLL (High-Level-Logic)-Pegel verstanden. TTL-Pegel sind in der Regel so genormt, dass die auf das Potential 0 bezogene Spannung zur Darstellung eines logischen High-Zustandes $\geqslant 2$ V und zur Darstellung eines logischen Low-Zustandes $\leqslant 0,8$ V sein muss. Die bei der ECL(Emitter-Coupled-Logic)-Technik auftretenden Pegel sind im allgemeinen ebenfalls auf das Potential 0 bezogen, weisen aber einen deutlich geringeren Störabstand zwischen High-Zustand und Low-Zustand auf. Z.B. muss bei ECL-Pegeln die Spannung zur Darstellung eines logischen High-Zustands $\geqslant -0,98$ V und zur Darstellung eines logischen Low-Zustands $\leqslant -1,63$ V sein. Schaltungsanordnungen der eingangs genannten Art sind z.B. aus The Integrated Circuits Catalog for Design Engineers, First Edition, Texas Instruments, 1971, S. 4-73 bis 4-84 oder aus Motorola MECL Integrated Circuits, 1978, S. 3-19 bekannt.

Um sowohl TTL- als auch ECL-Pegel auf die Spannung 0 beziehen zu können, benötigen die bekannten Schaltungsanordnungen zwei Versorgungsspannungen unterschiedlicher Polarität und somit eine aufwendigere Stromversorgung als Pegelumsetzer, die nur eine Versorgungsspannung benötigen.

Aufgabe der Erfindung ist es, hier Abhilfe zu schaffen und eine Schaltungsanordnung zur Pegelumsetzung vorzusehen, die geringe Verzögerungszeiten aufweist und nur eine einzige Versorgungsspannung benötigt.

Diese Aufgabe wird bei einer Schaltungsanordnung der eingangs genannten Art erfindungsgemäss durch einen ersten mittels emittergekoppelten npn-Transistoren ausgeführten Stromschalter und einen zweiten mittels zweier emittergekoppelten pnp-Transistoren ausgeführten Stromschalter, wobei der erste Transistor des zweiten Stromschalters als Eingangsstufe für den ersten Stromschalter angeordnet ist und die Schaltschwelle für den zweiten Stromschalter höher liegt als die des ersten Stromschalters, gelöst. Dadurch gelingt es, mit einer einzigen Versorgungsspannung z.B. die Spannung zur Darstellung eines logischen High-Zustandes $\geqslant V_{cc} - 0,8$ V und zur Darstellung eines logischen Low-Zustandes $\leqslant V_{cc} - 1,3$ V zu halten ($V_{cc}$=Versorgungsspannung).

Durch die erfindungsgemässe Schaltungsanordnung wird weiterhin eine Sättigung der Transistoren des 1. Stromschalters vermieden und somit eine geringe Verzögerungszeit erreicht. Ausgestaltungen der erfindungsgemässen Schaltungsanordnung sind in Unteransprüchen gekennzeichnet.

Die Erfindung wird im folgenden anhand der Figuren näher erläutert. Es zeigen:

Fig. 1 ein Ausführungsbeispiel für eine lediglich eine Versorgungsspannung benötigende Schaltungsanordnung mit einem Stromschalter,

Fig. 2 ein Ausführungsbeispiel für eine erfindungsgemässe Schaltungsanordnung mit 1. und 2. Stromschalter,

Fig. 3 eine grafische Darstellung des Leitungsverhaltens der Transistoren der Fig. 2 in Abhängigkeit von der Eingangsspannung und

Fig. 4 ein Impulsdiagramm der Verzögerungszeit eines Ausführungsbeispiels der erfindungsgemässen Schaltungsanordnung.

In den Figuren sind gleiche Elemente mit gleichen Bezugszeichen bezeichnet.

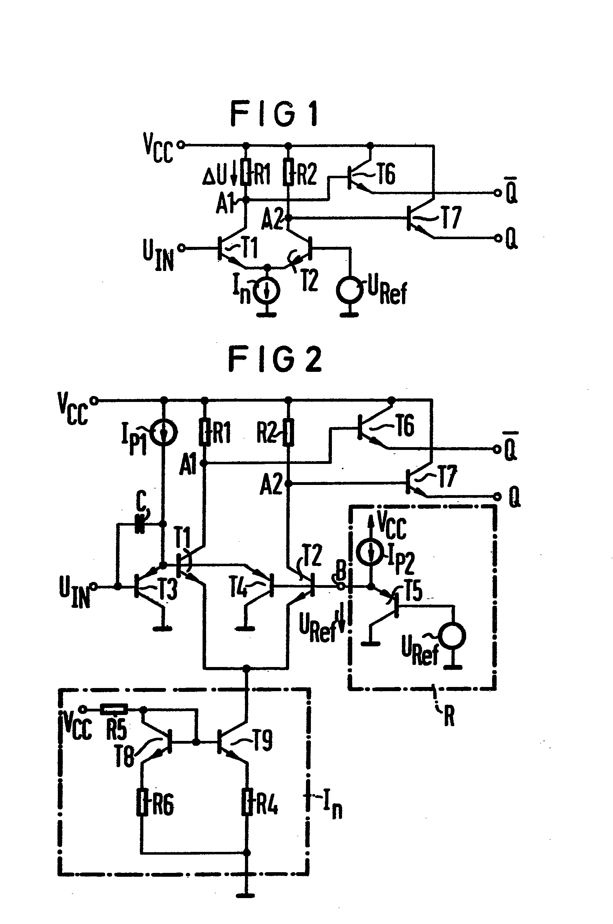

Im Ausführungsbeispiel der Fig. 1 beaufschlagt ein TTL-Pegel als Eingangssignal $U_{IN}$ einen aus zwei npn-Transistoren T1, T2 bestehenden Stromschalter. Der erste Transistor T1 und der zweite Transistor T2 des Stromschalters sind über ihre gekoppelten Emitter mit einer mit Masse verbundenen Stromquelle $I_n$ verbunden, die als übliche Konstantstromquelle, im einfachsten Fall als Widerstand, ausgeführt sein kann. Der Kollektor des ersten Transistors T1 ist über den Kollektorwiderstand R1 und der Kollektor des zweiten Transistors T2 über den Kollektorwiderstand R2 mit der Versorgungsspannung $V_{cc}$ verbunden.

Die Basis des ersten Transistors T1 wird vom Eingangssignal $U_{IN}$ beaufschlagt, während die Basis des zweiten Transistors T2 mit der, mit Masse verbundenen Referenzspannungsquelle $U_{ref}$ verbunden ist. Die Spannung der Referenzspannungsquelle $U_{ref}$ kann im einfachsten Fall mittels eines Spannungsteilers gewonnen werden und wird so gewählt, dass sie zwischen der Spannung des High-Zustandes und der Spannung des Low-Zustandes des Eingangssignals liegt. Vorteilhafterweise wird sie in der Mitte beider Signale liegend, d.h. bei etwa 1,4 V gewählt.

Am invertierenden Ausgang A1 des Stromwandlers ist entweder direkt oder über den als Emitterfolger angeschlossenen Transistor T6 der invertierte ECL-Pegel $\overline{Q}$ entnehmbar. Über den an den nicht invertierenden Ausgang A2 des Stromwandlers als Emitterfolger angeschlossenen Transistor T7 oder direkt am Ausgang A2 ist der nicht invertierte ECL-Pegel Q entnehmbar.

Der aus den beiden Transistoren T1 und T2 als Stromschalter ausgeführte Differenzverstärker arbeitet in der aus der ECL-Technik bekannten Weise, d.h. der Transistor mit dem im Vergleich zum anderen Transistor grösseren Basispotential wird durchgeschaltet. Die Widerstände R1 und R2 werden so dimensioniert, dass die Ausgangssignale Q bzw. $\overline{Q}$ bezogen auf die Versorgungsspannung $V_{cc}$ den gewünschten ECL-Hub $\Delta U$ aufweisen. Diese Auslegung kann z.B. in der Weise geschehen, dass der ECL-Pegel High $\geqslant V_{cc} - 0,8$ V und der ECL-

Pegel Low $\leqslant$ V$_{cc}$−1,3 V ist. Im Vergleich zu üblichen ECL-Stromschalterelementen arbeitet dieser Stromschalter jedoch mit auf Masse bezogener Referenzspannung U$_{ref}$. Liegt am Eingang U$_{IN}$ ein High-Pegel, so fällt am Widerstand R1 die Spannung $\Delta$U ab, am Widerstand R2 jedoch nicht, so dass am Ausgang $\overline{Q}$ ein Low-Pegel mit der Spannung V$_{cc}$−$\Delta$U−U$_{BE}$ (U$_{BE}$=Basis-Emitterschwellspannung des Emitterfolgertransistors T6) und am Ausgang Q ein High-Pegel anliegt.

Ist im umgekehrten Fall des Eingangssignal U$_{IN}$ Low, so leitet der Transistor T2, so dass das Ausgangssignal $\overline{Q}$ High-Pegel und das Ausgangssignal Q Low-Pegel aufweist.

Das gezeigte Ausführungsbeispiel zeigt also einen Pegelumwandler, der nur eine Versorgungsspannung benötigt, bei dem die Ausgangspegel aufgrund ihres Bezuges auf die Versorgungsspannung ebenfalls schwanken.

Entsprechende Pegelwandler sind insbesondere dann von Vorteil, wenn ein integrierter Schaltkreis von aussen mit TTL-Pegeln und einer der TTL-Technik entsprechenden Versorgungsspannung (z.B. +5 V) beaufschlagt wird, jedoch intern aus Gründen der Geschwindigkeit ECL-Technik verwendet werden soll.

Um die Verzögerungszeit des Pegelwandlers möglichst gering zu halten, empfiehlt es sich, sowohl chip-intern als auch für die Transistoren T1 und T2 npn-Transistoren zu verwenden. Die Schaltungsanordnung nach Fig. 1 hat jedoch dann Nachteile, wenn das Eingangssignal U$_{IN}$ grösser als die Versorgungsspannung V$_{cc}$ ist, da dann der Transistor T1 in Sättigung arbeitet und der Pegelwandler daher zu grosse Verzögerungszeit aufweist. Weiterhin kann an der Basis-Emitter-Strecke des Transistors T2 eine hohe Sperrspannung anfallen. Da die Basis-Emitter-Strecken bei schnellen Transistoren jedoch niedrige Durchbruchspannungen aufweisen, besteht dann die Gefahr der Zerstörung des Transistors T2.

Um diese Nachteile zu vermeiden, ist erfindungsgemäss vorgesehen, den aus zwei npn-Transistoren T1 und T2 bestehenden ersten (aktiven) Stromschalter durch einen zweiten, aus ebenfalls emittergekoppelten, jedoch aus pnp-Transistoren T3 und T4 bestehenden Stromschalter zu ergänzen. Die pnp-Transistoren können vorteilhafterweise als Substrat-pnp, deren Kollektor stets an Masse liegen muss, ausgeführt werden. Ein Ausführungsbeispiel einer entsprechenden Anordnung zeigt die Fig. 2. Für Ausführung und Funktion der Transistoren T1, T2 der Kollektorwiderstände R1, R2 der Emitterfolger T6, T7 und der Stromquelle I$_n$ gelten die Ausführungen zur Fig. 1 entsprechend. Der zweite Stromschalter besteht aus zwei pnp-Transistoren T3 und T4, wobei der erste Transistor T3 des zweiten Stromschalters als Eingangsstufe für den ersten Transistor T1 des ersten Stromschalters geschaltet ist. Die Schaltschwelle für den zweiten Stromschalter liegt höher als die des ersten Stromschalters. Im gezeigten Ausführungsbeispiel der Fig. 2 wird dies dadurch realisiert, dass die Eingangsspannung U$_{IN}$ die Basis des ersten Transistors T3 des zweiten Stromschalters beaufschlagt, dessen Kollektor mit Masse verbunden ist und dessen Emitter einerseits über die Stromquelle I$_{p1}$ mit der Versorgungsspannung V$_{cc}$ und andererseits mit der Basis des ersten Transistors T1 des ersten Stromschalters verbunden ist. Der zweite Transistor T4 des zweiten Stromschalters ist so angeordnet, dass sein Emitter mit der Basis des ersten Transistors T1 des ersten Stromschalters, seine Basis mit der Basis des zweiten Transistors T2 des ersten Stromschalters und sein Kollektor mit Masse verbunden sind. Somit liegt die Schaltschwelle für den zweiten Stromschalter um eine Basis-Emitterschwellspannung höher als die des ersten Stromschalters.

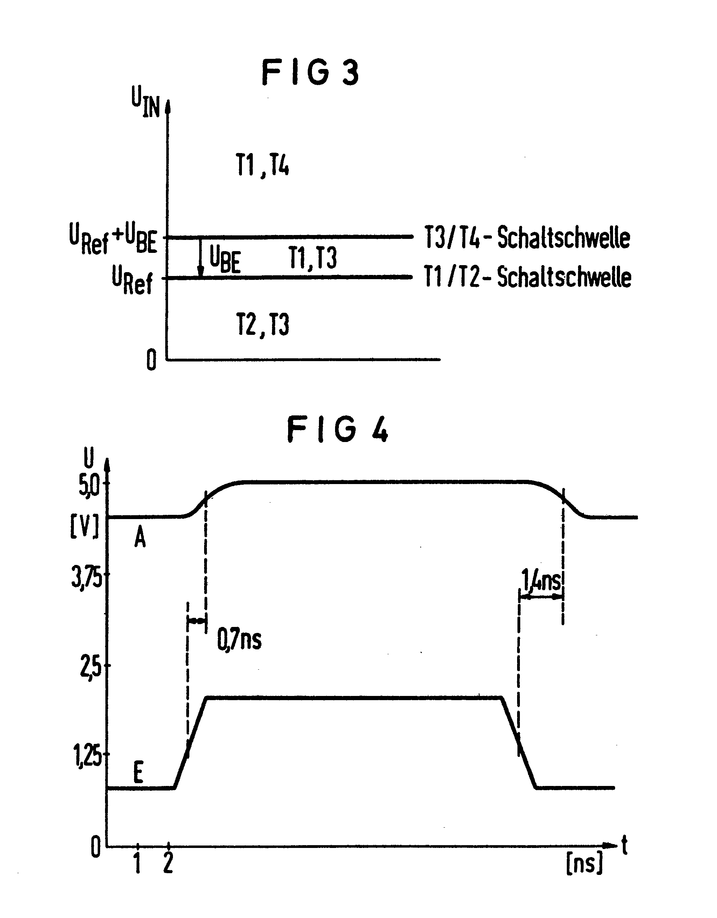

Die Leitungsverhältnisse der Transistoren T1, T2, T3, T4 in Abhängigkeit von der Eingangsspannung U$_{IN}$ zeigt die Fig. 3. Der grafischen Darstellung der Fig. 3 liegt eine an Punkt B liegende Spannung U$_{ref}$ zugrunde, die aus der Summe einer Referenzspannung U$_{ref}$ und einer Basis-Emitter-Schwellspannung U$_{BE}$ gebildet ist. Eine entsprechende Spannung kann beispielsweise gemäss der in der Fig. 2 im gestrichelten Kasten R gezeigten Schaltungsanordnung gewonnen werden. Die Schaltungsanordnung R sieht eine an Masse gekoppelte Referenzspannung U$_{ref}$ (z.B. 1,4 V) vor, die an der Basis des pnp-Transistors T5 anliegt, dessen Kollektor an Masse liegt und dessen Emitter einerseits mit dem Punkt B und andererseits über eine Stromquelle I$_{p2}$ mit der Versorgungsspannung V$_{cc}$ verbunden ist, d.h. der Transistor T5 ist als Emitterfolger geschaltet. Um identische Basis-Emitter-Schwellen der Transistoren T3 und T5 zu erreichen, werden vorteilhafterweise die Stromquellen I$_{p1}$ und I$_{p2}$ so ausgeführt, dass die durch die Transistoren T3 und T5 fliessenden Ströme gleich sind.

Ist die Eingangsspannung U$_{IN}$ kleiner als die Schaltschwelle des aus den Transistoren T1 und T2 gebildeten Stromwandlers (T1/T2-Schaltschwelle), d.h. kleiner als die Referenzspannung U$_{ref}$, so leitet der Transistor T2 und der ein tieferes Basispotential aufweisende Transistor T3, so dass am Ausgang Q ein Low-Signal anliegt. Liegt die Eingangsspannung U$_{IN}$ zwischen der T1/T2-Schaltschwelle und der T3/T4-Schaltschwelle (der Schaltschwelle des aus den Transistoren T3 und T4 gebildeten Stromschalter, d.h. der Spannung U$_{ref}$ + U$_{BE}$), so leiten die Transistoren T3 und T1, so dass das Ausgangssignal Q High-Pegel aufweist. Ist das Eingangssignal U$_{IN}$ grösser als die T3/T4-Schaltschwelle, so leiten die Transistoren T1 und T4. Die hohe Eingangsspannung fällt also an der Basis-Emitter-Strecke des pnp-Transistors T3 ab, die Spannung an der Basis-Emitter-Strecke des npn-Transistors T2 wird auf etwa 0 V begrenzt. Da pnp-Transistoren im allgemeinen grössere Basis-Emitter-Spannungen vertragen als npn-Transistoren, ist die Schaltungsanordnung nach Fig. 2 daher zuverlässiger als die nach Fig. 1.

Eine Sättigung des Transistors T1 bei hohen Eingangsspannungen ist bei der erfindungsgemässen Schaltungsanordnung vermieden, da das Basispotential des Transistors T1 nicht über die Summe der Spannungen U$_{ref}$ + U$_{BE}$ ansteigen kann. Weiterhin werden negative Eingangsspannungen $U_{IN}$ mittels der Basiskollektordiode des Transistors T3 begrenzt.

Die Stromquellen $I_n$, $I_{p1}$ und $I_{p2}$ können als übliche Konstantstromquellen, im einfachsten Fall als Widerstände realisiert werden. Die Referenzspannung $U_{ref}$ wird vorteilhafterweise so gewählt, dass sie in der Mitte zwischen TTL-Pegel High und TTL-Pegel Low liegt, also auf etwa 1,4 V. Die Stromverstärkung der Transistoren T1 bis T4 ist im allgemeinen so gross, dass ihre Basisströme zu vernachlässigen sind.

Da pnp-Transistoren bei Verwendung üblicher Prozesse für schnelle integrierte Schaltkreise im allgemeinen relativ langsam sind, wird vorteilhafterweise zwischen Basis und Kollektor des ersten Transistors T3 des zweiten Stromschalters eine Koppelkapazität C geschaltet, so dass für kurze Zeiten die Kapazität C und nicht der Transistor T3 den Eingangspegel verschiebt. Die Kapazität C kann als Sperrschichtkapazität der Basis-Emitter-Diode des Transistors T3 ausgeführt sein.

In einem Ausführungsbeispiel nach Fig. 2 betrugen die von den Stromquellen $I_{p1}$ und $I_{p2}$ erzeugten Ströme je 0,25 mA, der von der Stromquelle $I_n$ erzeugte Strom 0,6 mA, die Referenzspannung $U_{ref}$ 1,4 V die Basis-Emitter-Schwellspannungen der Transistoren T1 bis T7 0,8 V, die Kapazität C 1,2 pF, die Widerstände R1 und R2 je 830 Ohm. Die Stromquelle $I_{p1}$ wurde durch einen 12-kOhm-Widerstand realisiert. Die Referenzspannung $U_{ref}$ wurde als temperatur- und versorgungsspannungskompensiertes Netzwerk (sogenannte band-gap-referenz) realisiert. Die npn-Transistoren weisen eine Emitterfläche (Fläche des Emitter-Implantationsgebietes in Aufsicht) von 40 $\mu m^2$ auf, ihre Emitter-Basis-Kapazitäten und Kollektor-Basis-Kapazitäten betrugen je 0,1 pF, ihre Kollektor-Substrat-Kapazität 0,45 pF. Die npn-Transistoren T3, T4 und T5 wurden in üblicher Weise als Substrat-Transistoren, deren Kollektor immer auf Masse liegt, ausgeführt.

Transistor T5 dient als Gegenstück zu T3, wodurch die Schaltschwelle des ersten Stromschalters (T1, T2) temperaturkompensiert wird. T3 und T5 müssen daher mit annähernd dem gleichen Emitterstrom betrieben werden.

Die Stromquelle $I_n$ ist, wie in der Fig. 2 im gestrichelten Kasten dargestellt, als Stromspiegel mit Transistordiode realisiert, die Widerstände R4 und R6 betragen 330 Ohm, der Widerstand R5 6,75 kOhm.

Der zeitliche Verlauf eines am Eingang $U_{IN}$ anliegenden Eingangsimpulses E und der zeitliche Verlauf des am Ausgang Q abgegebenen Ausgangsimpulses A sind der Fig. 4 zu entnehmen. Die Verzögerungszeit von Pegelmittel der steigenden Flanke von Eingangsimpuls E zu Ausgangsimpuls A betrug lediglich 0,7 ns, die Verzögerungszeit von Pegelmittel der fallenden Flanke von Eingangsimpuls E zu Ausgangsimpuls A lediglich 1,4 ns.

Somit gelingt es, einen schnellen TTL ECL-Pegelwandler zu schaffen, der vorteilhafterweise für einen integrierten Schaltkreis, der intern in ECL-Schaltungstechnik aufgebaut ist, aussen TTL-kompatible Anschlüsse aufweist und ausschliesslich mit einer Versorgungsspannung (z.B. +5 V) betrieben wird, verwendbar ist.

## Patentansprüche

1. Schaltungsanordnung zur Pegelumsetzung von TTL-Logik-Pegeln zu ECL-Logik-Pegeln mit mindestens einem eingangsseitig von TTL-Logik-Pegeln beaufschlagten emittergekoppelten Stromschalter, an dessen Ausgang ECL-Logik-Pegel entnehmbar sind, gekennzeichnet durch einen ersten mittels zweier emittergekoppelten npn-Transistoren (T1, T2) ausgeführten Stromschalter und einen zweiten mittels zweier emittergekoppelten pnp-Transistoren (T3, T4) ausgeführten Stromschalter, wobei der erste Transistor (T3) des zweiten Stromschalters (T3, T4) als Eingangsstufe für den ersten Stromschalter (T1, T2) angeordnet ist und die Schaltschwelle für den zweiten Stromschalter (T3, T4) höher liegt als die des ersten Stromschalters (T1, T2).

2. Schaltungsanordnung nach Anspruch 1, dadurch gekennzeichnet, dass die Schaltschwelle für den zweiten Stromschalter (T3, T4) um etwa eine Basis-Emitter-Schwellspannung höher liegt als die des ersten Stromschalters (T1, T2).

3. Schaltungsanordnung nach Anspruch 1 oder 2, dadurch gekennzeichnet, dass die ECL-Logik-Pegel an mindestens einem Ausgang (A1, A2) des ersten Stromschalters (T1, T2) entnehmbar sind.

4. Schaltungsanordnung nach der Ansprüche 1 bis 3, dadurch gekennzeichnet, dass die Referenzspannung ($U_{ref}$) für beide Stromschalter (T1, T2; T3, T4) so gewählt ist, dass

$$U_{TTL0} + U_{BE} < U_{ref} < U_{TTL1} + U_{BE}$$

mit

$U_{TTL0}$ = TTL-Eingangspegel Low
$U_{TTL1}$ = TTL-Eingangspegel High
$U_{BE}$ = Basis-Emitter-Schwellspannung

5. Schaltungsanordnung nach einem der Ansprüche 1 bis 4, dadurch gekennzeichnet, dass die Referenzspannung ($U_{ref}$) für beide Stromschalter (T1, T2; T3, T4) so gewählt ist, dass

$$U_{ref} = \frac{U_{TTL0} + U_{TTL1}}{2} + U_{BE}$$

6. Schaltungsanordnung nach einem der Ansprüche 1 bis 5, dadurch gekennzeichnet, dass zwischen Basis und Emitter des ersten Transistors (T3) des zweiten Stromschalters (T3, T4) eine Koppelkapazität (C) geschaltet ist.

7. Schaltungsanordnung nach einem der Ansprüche 1 bis 6, dadurch gekennzeichnet, dass der erste Stromschalter (T1, T2) aus zwei emittergekoppelten Transistoren (T1, T2) besteht, deren Emitter mit einer Stromquelle ($I_n$) verbunden sind, deren Kollektoren über Kollektorwiderstände (R1, R2) mit der Versorgungsspannung ($V_{cc}$) verbunden sind und an deren Kollektoren insbesondere über nachgeschaltete Emitterfolger (T6, T7) die ECL-Logik-Pegel entnehmbar sind, wobei die nicht invertierten Pegel (Q) am Kollektor des zweiten (T2) und die invertierten Pegel ($\overline{Q}$) am Kollektor des ersten Transistors (T1) entnehmbar sind und dass der zweite Stromschalter (T3, T4) aus zwei emittergekoppelten Transistoren (T3, T4) besteht, deren Emitter mit der Basis des ersten Transistors (T1) des ersten Stromwandlers (T1, T2) und mit einer Stromquelle ($I_{p1}$) und deren Kollektoren mit Masse verbunden sind, wobei die Basis des ersten Transistors (T3) des zweiten Stromschalters (T3, T4) von den TTL-Logik-Pegeln ($U_{IN}$) beaufschlagbar ist und die Basis des zweiten Transistors (T4) des zweiten Stromschalters (T3, T4) mit der Basis des zweiten Transistors (T2) des ersten Strsomschalters (T1, T2) und mit der Referenzspannung ($U_{ref}$) verbunden ist.

## Claims

1. A circuit for level conversion of TTL logic levels to ECL logic levels comprising at least one emitter-coupled electric switch, which is acted upon at the input end by TTL-logic levels and at whose output ECL logic levels can be obtained, characterised by a first electric switch formed by two emitter-coupled npn transistors (T1, T2), and by a second electric switch constructed of two emitter-coupled pnp transistors (T3, T4), where the first transistor (T3) of the second electric switch (T3, T4) is arranged as an input stage for the first electric switch (T1, T2) and the switching threshold for the second electric switch (T3, T4) lies higher than that of the first electric switch (T1, T2).

2. A circuit as claimed in Claim 1, characterised in that the switching threshold for the second electric switch (T3, T4) is higher than that of the first electric switch (T1, T2) by approximately one base emitter threshold voltage.

3. A circuit as claimed in Claim 1 or Claim 2, characterised in that the ECL-logic levels can be obtained at least one output (A1, A2) of the first electric switch (T1, T2).

4. A circuit as claimed in one of Claims 1 to 3, characterised in that the reference voltage ($U_{ref}$) for the two electric switches (T1, T2; T3, T4) is selected to be as follows:

$$U_{TTLO} + U_{BE} < U_{ref} < U_{TTL1} + U_{BE}$$

where
$U_{TTLO}$ = TTL input level Low
$U_{TTL1}$ = TTL input level High
$U_{BE}$ = Base emitter threshold voltage

5. A circuit as claimed in one of Claims 1 to 4, characterised in that the reference voltage ($U_{ref}$) for both electric switches (T1, T2; T3, T4) is selected to be such that

$$U_{ref} = \frac{U_{TTLO} + U_{TTL1}}{2} + U_{BE}$$

6. A circuit as claimed in one of Claims 1 to 5, characterised in that a coupling capacitance (C) is inserted between the base and emitter of the first transistor (T3) and the second electric switch (T3, T4).

7. A circuit as claimed in one of Claims 1 to 6, characterised in that the first electric switch (T1, T2) consists of two emitter-coupled transistors (T1, T2), whose emitters are connected to a current source ($I_n$), whose collectors are connected to the supply voltage ($V_{cc}$) by means of collector resistances (R1, R2) and at whose collectors the ECL logic levels can be obtained, in particular by means of subsequent emitter followers (T6, T7), where the non-inverting levels (Q) can be obtained at the collector of the second transistor (T2) and the inverting levels ($\overline{Q}$) at the collector of the first transistor (T1), and that the second electric switch (T3, T4) consists of two emitter-coupled transistors (T3, T4), whose emitters are connected to the base of the first transistor (T1) of the first current transformer (T1, T2) and to a current source ($I_{p1}$) and whose collectors are connected to earth, where the base of the first transistor (T3) of the second electric switch (T3, T4) is acted upon by the TTL logic levels ($U_{IN}$) and the base of the second transistor (T4) of the second electric switch (T3, T4) is connected to the base of the second transistor (T2) of the first electric switch (T1, T2) and to the reference voltage ($U_{ref}$).

## Revendications

1. Montage pour la conversion de niveaux des niveaux de logiques TTL en niveaux de logiques ECL, du type comportant au moins un commutateur de courant à couplage par émetteurs, chargé du côté entrée par des niveaux de logiques TTL et à la sortie duquel un niveau de logique ECL peut être prélevé, caractérisé par un premier commutateur de courant réalisé à l'aide de deux transistors npn (T1, T2) en montage à couplage par émetteurs, et par un second commutateur de courant réalisé à l'aide de deux transistors pnp (T3, T4) en montage à couplage par émetteurs, le premier transistor (T3) du second commutateur de courant (T3, T4) étant agencé comme étage d'entrée pour le premier commutateur de courant (T1, T2), et le seuil de commutation pour le second commutateur de courant (T3, T4) étant situé à un niveau plus haut que celui du premier commutateur de courant (T1, T2).

2. Montage selon la revendication 1, caractérisé par le fait que le seuil de commutation pour le second commutateur de courant (T3, T4) est situé sensiblement d'une tension de seuil base-émetteur plus haut que celle du premier commutateur de courant (T1, T2).

3. Montage selon la revendication 1 ou 2, caractérisé par le fait que les niveaux des logiques ECL sont susceptibles d'être prélevés au niveau d'au moins une sortie (A1, A2) du premier commutateur de courant (T1, T2).

4. Montage selon les revendications 1 à 3, caractérisé par le fait que la tension de référence

($U_{ref}$) pour les deux commutateurs de courant (T1, T2; T3, T4) est choisie de telle façon que

$$U_{TTL0} + U_{BE} < U_{ref} < U_{TTL1} + U_{BE}$$

avec

$U_{TTL0}$=niveau d'entrée TTL bas
$U_{TTL1}$=niveau d'entrée TTL haut
$U_{BE}$=tension de seuil base-émetteur

5. Montage selon l'une des revendications 1 à 4, caractérisé par le fait que la tension de référence ($U_{ref}$) pour les deux commutateurs de courant (T1, T2; T3, T4) est choisie de telle façon que

$$U_{ref} = \frac{U_{TTL0} + U_{TTL1}}{2} + U_{BE}$$

6. Montage selon l'une des revendications 1 à 5, caractérisé par le fait qu'entre la base et l'émetteur du premier transistor (T3) du second commutateur de courant (T3, T4) est montée une capacité de couplage (C).

7. Montage selon l'une des revendications 1 à 6, caractérisé par le fait que le premier commutateur de courant (T1, T2) est constitué par deux transistors (T1, T2) à couplage par émetteurs, dont les émetteurs sont reliés à une source de courant ($I_n$), dont les collecteurs sont reliés, par l'intermédiaire de résistances de collecteurs (R1, R2), à la tension d'alimentation ($V_{cc}$), et aux collecteurs desquels on peut prélever, en particulier par l'intermédiaire d'émetteurs communs aval (T6, T7), le niveau de la logique ECL, les niveaux (Q) non inversés sont susceptibles d'être prélevés au niveau du collecteur du second transistor (T2) et les niveaux inversés ($\overline{Q}$) peuvent être prélevés au niveau du collecteur du premier transistor (T1), et que le second commutateur de courant (T3, T4) est constitué par deux transistors (T3, T4) à couplage par émetteurs, dont les émetteurs sont reliés à la base du premier transistor (T1) du premier commutateur de courant (T1, T2) et à une source de courant ($I_{p1}$), et dont les collecteurs sont reliés à la masse, la base du premier transistor (T3) du second commutateur de courant (T3, T4) est susceptible d'être chargée par les niveaux ($U_{IN}$) des logiques TTL, et la base du second transistor (T4) du second commutateur de courant (T3, T4) est reliée à la base du second transistor (T2) du premier commutateur de courant (T1, T2) et à la tension de référence ($U_{ref}$).

# F I G 1

# F I G 2

# F I G 3

# F I G 4